# EUROPEAN PATENT SPECIFICATION

(11) **EP 4 154 020 B1**
(45) Date of publication and mention of the grant of the patent: **18.02.2026**
(21) Application number: 21728102.1
(22) Date of filing: 18.05.2021
(51) Int. Cl.: G01P 15/097, B81B 5/00, G01P 15/08

(54) **SINGLE AXIS RESONANT ACCELEROMETER**
EINACHSIGER RESONANTER BESCHLEUNIGUNGSMESSER
ACCÉLÉROMÈTRE RÉSONANT À AXE UNIQUE

(30) Priority: 21.05.2020 GB 202007598
(43) Date of publication of application: 29.03.2023
(73) Proprietor: Silicon Microgravity Limited, Cambridge Innovation Park, Waterbeach, Cambridgeshire CB25 9GL (GB)
(72) Inventor: SESHIA, Ashwin, Cambridge Cambridgeshire CB3 0FF (GB); ZHAO, Chun, Cambridge Cambridgeshire CB3 0FF (GB)
(74) Representative: Reddie & Grose LLP
(86) International application number: PCT/GB2021/051197
(87) International publication number: WO 2021/234372

(56) References cited:
- EP-A1- 2 577 324
- WO-A1-2018/197857
- US-A1- 2008 314 147
- US-A1- 2020 025 790

## Description

### Field of the Invention

The invention relates to accelerometers. In particular, the invention relates to accelerometer designs that have reduced sensitivity to external stresses.

### Background to the Invention

A resonant sensor is an oscillator whose output resonant frequency is a function of an input measurand. In other words, the output of a resonant sensor corresponds to the shift in resonant frequency of a mechanical microstructure that gets tuned in accordance with a change in a physical quantity to be measured.

There has been an increased interest over the past few years in the development of high precision micromachined 'all-silicon' resonant micro-accelerometers. This interest has been triggered due to the recent growth in demand for miniature high precision motion sensors within the aerospace, automotive and even the consumer-electronics markets. Resonant micro-accelerometers fabricated using silicon micromachining techniques present a number of significant advantages, the biggest being economy. These silicon resonant micro-accelerometers not only boast improved sensitivity and resolution relative to their more traditional capacitive detection based counterparts with similar device footprints, but have also been shown to provide enhanced dynamic range making them ideal candidates for potential application in numerous motion sensing applications within the identified markets. One potential sensing application is gravimetry. Resonant accelerometers can be designed to provide a low-noise response for near-DC measurements (suitable for applications in gravimetry) and a wide dynamic range enabling measurements over the entire +/-1g regime.

However, MEMS resonant accelerometers can be affected by external stresses, resulting, for example, from temperature and pressure variations. Even in designs that use a differential output to cancel common mode effects, the different stresses experienced by different resonant elements can limit the accuracy of the sensor.

It would be desirable to produce a resonant sensor that is less sensitive to external stresses in a compact design.

WO 2018/197857 A1 discloses a resonant sensor comprising a substrate and a proof mass suspended from the substrate by one or more flexures to allow the proof mass to move relative to the frame along a sensitive axis. A first resonant element and a second resonant element are connected between the frame and the proof mass. The first resonant element and the second resonant element are positioned so that the proof mass is between the first resonant element and the second resonant element along the sensitive axis.

US 2008/314147 A1 discloses an accelerometer. The accelerometer comprises an actuator substrate; a reference substrate; and at least one moving proof mass on the actuator substrate. The proof mass is anchored to a cover plate at a single point, on the reference substrate with at least one flexure spring. The accelerometer also includes at least one electrode coupled to each proof mass, wherein a capacitance of the electrode increases and decreases with the motion of the other proof mass.

EP 2577324 A1 discloses an inertial sensor. The inertial sensor comprises a frame, a proof mass, and a first resonant element having a proximal end and a distal end. The first resonant element is fixed to the frame at its proximal end and coupled to the proof mass at its distal end. The inertial sensor further comprises a second resonant element having a proximal end and a distal end, the second resonant element being fixed to the frame at its proximal end, adjacent to the first resonant element such that there is no coupling between the second resonant element and the proof mass. The inertial sensor further comprises a means for coupling the first resonant element to the second resonant element; a drive means coupled to the first and second resonant elements for vibrating the first and second resonant elements; and a sensor assembly for detecting the amplitude of vibration of the resonant elements.

US 2020/025790 A1 discloses a vibrating beam accelerometer with an in-plane translational proof mass that may include at least two or more resonators and be built with planar geometry, discrete lever arms, four-fold symmetry and a single primary mechanical anchor between the support base and the vibrating beam accelerometer. The vibrating beam accelerometer of may be built according to a micro-electromechanical systems fabrication process. Use of a single primary mechanical anchor may minimize bias errors that can be caused by external mechanical forces applied to the circuit board, package, and/or substrate that contains the accelerometer mechanism.

### Summary of the Invention

In a first aspect, there is provided an accelerometer comprising:
a frame;
one or more proof masses suspended from the frame by one or more flexures and movable relative to the frame along a sensing axis;
a first resonant element fixed between an anchor on the frame and the one or more proof masses, and extending from the anchor to the one or more proof masses along the sensing axis; and
a second resonant element fixed between the anchor and the one or more proof masses and extending from the anchor to the one or more proof masses along the sensing axis in an opposite direction to the first resonant element.

Having both first and second resonant elements fixed to the same anchor on the frame means that they will both be subject to substantially the same thermal and mechanical stresses. This means that a differential output based on the response of the first and second resonant elements will result in cancellation of substantially all effects associated with the thermal and mechanical stresses. The first and second resonant elements are advantageously substantially co-linear.

The accelerometer comprises drive circuity configured to drive the first and second resonant elements into resonance and sense circuitry configured to detect changes in the resonant behaviour of the first and second resonant elements. The sense circuitry advantageously provides an output based on a difference between a resonant frequency of the first resonant element and a resonant frequency of the second resonant element.

The drive circuitry may be configured to drive the first and second resonant elements into different resonant modes to one another, having different resonant frequencies. This reduces mode coupling between the first and second resonant elements.

The first and second resonant elements are double ended tuning fork resonant elements. This resonant element topology results in cancellation of stress waves for the out-of-phase tuning fork resonant mode at the anchor, reducing coupling between the resonant elements, which can be a source of signal interference or injection locking between the two resonant elements.

Advantageously, the first and second resonant elements are substantially identical to one another. This simplifies the processing of the output signals.

The one or more proof masses may consist of a single proof mass surrounding the anchor. This allows for the maximum possible mass for the one or more proof masses in the available space, and so maximises the strain on the first and second resonant elements for a given input acceleration. Alternatively, the one or more proof masses may consist of two substantially identical proof masses positioned on opposite sides of the anchor.

The accelerometer may comprise a force amplifying lever between the first or second resonant element and the one or more proof masses. Force amplifying levers can be used to improve the sensitivity of the accelerometer to small changes in acceleration.

The frame, one or more proof masses, resonant elements and flexures may all be formed from a single piece of semiconductor material, such as silicon. The one or more proof masses, resonant elements and flexures may all be etched or machined from a single piece of semiconductor material, such as silicon. The accelerometer may be a micro electrical mechanical systems (MEMS) device.

In another aspect, there is provided a gravimeter comprising an accelerometer in accordance with the first aspect.

In a further aspect, there is provided a borehole tool comprising an accelerometer according to the first aspect or a gravimeter in accordance with the second aspect.

### Brief Description of the Drawings

Embodiments of the invention will now be described, by way of example only, with reference to the accompanying drawings, in which:
Figure 1 is a schematic illustration of first embodiment of the invention (separate proof masses DEFT);
Figure 2 is a schematic illustration of a second embodiment of the invention (single proof mass);
Figure 3 illustrates drive and sense circuitry suitable for the embodiments of Figures 1 and 2;
Figure 4 illustrates possible mode shapes for the DETF resonant elements; and
Figure 5 is a schematic illustration of a borehole tool incorporating an accelerometer in accordance with the invention.

### Detailed Description

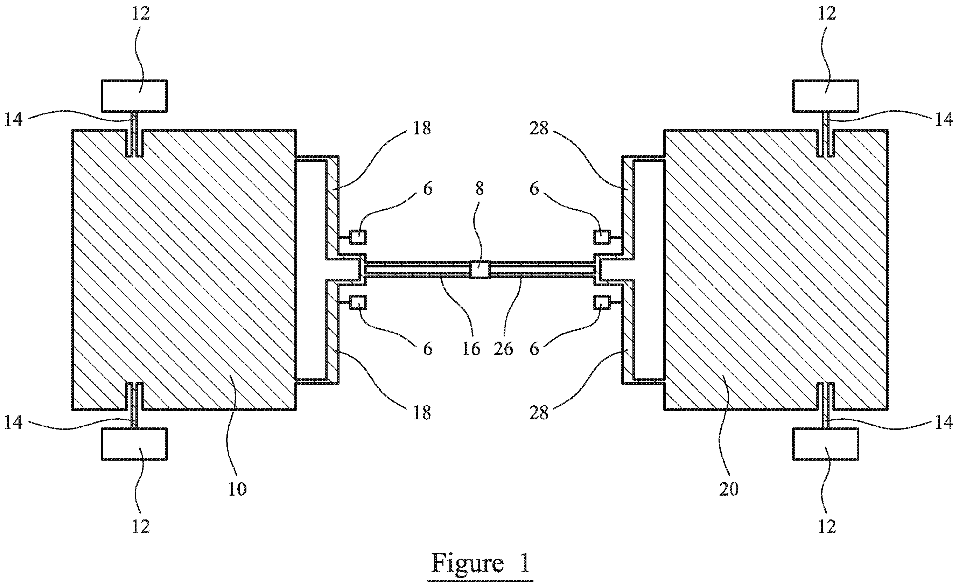

Figure 1 is a schematic illustration of a top view of an accelerometer in accordance with the present invention. The accelerometer is advantageously fabricated entirely from a single semiconductor wafer, such as a silicon-on-insulator (SOI) wafer.

The accelerometer comprises a first proof mass 10 and a second proof mass 20. The first proof mass is suspended from a frame 12 by flexures 14 so as to allow movement of the first proof mass along an axis, towards and away from the second proof mass. The second proof mass 20 is suspended from the frame 12 by flexures 14 in the same way, so as to allow movement of the second proof mass along the same axis, towards and away from the first proof mass. The axis is the sensitive axis of the accelerometer.

A first resonant element 16 is connected between an anchor 8 and the first proof mass 10. The anchor 8 is part of the frame 12. The first resonant element extends along the sensitive axis. The first resonant element 16 is connected to the first proof mass 10 through amplifying levers 18. The amplifying levers 18 are fixed to the frame at pivot points 6.

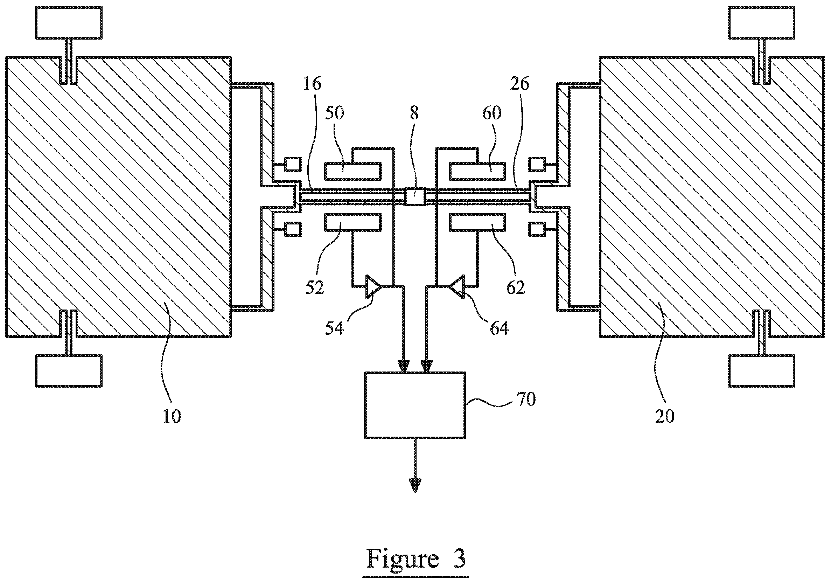

In operation, the first resonant element driven into a first mode of vibration having a first resonant frequency. An arrangement for driving the first resonant element is described with reference to Figure 3, below. Movement of the first proof mass 10 toward or away from the anchor 8 as a result of an acceleration of the first proof mass causes a strain on the first resonant element 16, which alters the first resonant frequency of the first resonant element. Depending on the direction of movement of the first proof mass, the first resonant element 16 will experience a compressive or tensile strain. A compressive strain will shift the first resonant frequency in a different direction to a tensile strain. The amount of strain experienced by the first resonant element is amplified by the force amplifying levers 18. The greater the strain on the first resonant element, the greater the shift in the first resonant frequency. By detecting shifts in the resonant frequency of the first resonant element, a measure of acceleration can be obtained.

The second resonant element 26 is arranged in the same way to provide a measure of acceleration. But by taking a differential output from the first and second resonant elements, the influence of effects such as variations in temperature and pressure, or mechanical stresses on the accelerometer, can be cancelled out.

The second resonant element 26 in this embodiment is identical to the first resonant element 16. The second proof mass is also identical to first proof mass, and the force amplifying levers 28 are identical to the force amplifying levers 18. This makes providing a differential output from the first and second resonant elements more straightforward and ensures that the common mode effects, such as temperature variations, affect each resonant element to the same extent.

The second resonant element is also driven into vibration at a resonant frequency, which will change when the second resonant element undergoes a strain. The second resonant element extends along the same sensitive axis as the first resonant element, but in an opposite direction. This means that when the accelerometer undergoes an acceleration, the second resonant element 26 experiences an equal but opposite strain to the first resonant element 16. So when the resonant frequency of the first resonant element is shifted up as a result of an acceleration, the resonant frequency of the second resonant element will be shifted down. However any shifts in resonant frequency dues to thermal or mechanical stresses on the accelerometer will result in a shift in resonant frequency in the same direction for both the first resonant element and the second resonant element.

In the arrangement shown in Figure 1, the second resonant element 26 is connected to the same anchor 8 as the first resonant element. They are also axially aligned. This means that they will both be subject to substantially the same thermal and mechanical stresses. A differential output based on the response of the first and second resonant elements will therefore result in cancellation of substantially all effects associated with the thermal and mechanical stresses.

In the embodiment shown in Figure 1, the first and second resonant elements 16, 26 are double ended tuning fork (DEFT) resonant elements. This particular form of resonant element is advantageous because any stress waves generated by the out-of-phase tuning fork resonant mode are cancelled out at the anchor 8. This reduces any coupling between the resonant elements, which can be a source of signal interference or injection locking.

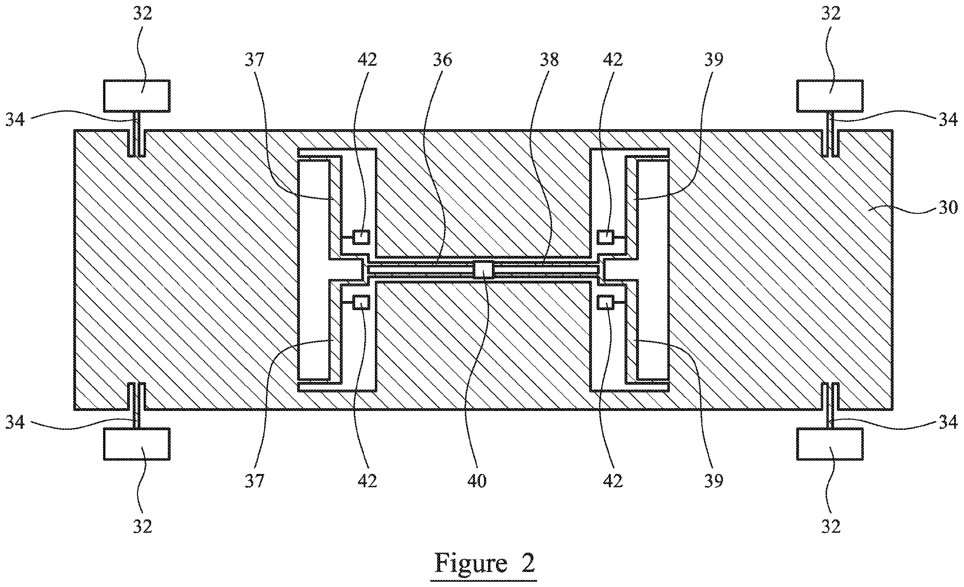

Figure 2 illustrates a second embodiment in accordance with the invention that operates in the same way. The arrangement of Figure 2 is identical to the arrangement of Figure 1, except that instead of two separate proof masses, a single proof mass is used that is connected to both a first and a second resonant element. In effect the first and second proof masses 10 and 20 of the first embodiment are joined together in the second embodiment.

The accelerometer comprises a proof mass 30. The proof mass is suspended from a frame 32 by flexures 34 so as to allow movement of the proof mass along an axis aligned with the first and second resonant elements 36, 38. The axis is the sensitive axis of the accelerometer.

A first resonant element 36 is connected between an anchor 40 and the proof mass 30. The anchor 40 is part of the frame 32. The first resonant element 36 is connected to the proof mass 30 through amplifying levers 37. The amplifying levers 37 are fixed to the frame at pivot points 42. A second resonant element 38 is connected between the anchor 40 and the proof mass 30 but extends from the anchor in the opposite direction to the first resonant element 36.The second resonant element 38 is connected to the proof mass 30 through amplifying levers 39. The amplifying levers 39 are fixed to the frame at pivot points 42.

The second resonant element 38 in this embodiment is identical to the first resonant element 36 and the force amplifying levers 37 are identical to the force amplifying levers 39. This makes providing a differential output from the first and second resonant elements more straightforward and ensures that the common mode effects, such as temperature variations, affect each resonant element to the same extent.

In operation, the first resonant element driven into a first mode of vibration having a first resonant frequency. The second resonant element is driven into a second mode of vibration having a second resonant frequency. The first mode of vibration may be the same as or different to the second mode of vibration, as explained below. An arrangement for driving the first and second resonant elements is described with reference to Figure 3, below.

As in the first embodiment, described with reference to Figure 1, when the accelerometer undergoes an acceleration along the sensitive axis, the second resonant element 38 experiences an equal but opposite strain to the first resonant element 36. So when the resonant frequency of the first resonant element is shifted up as a result of an acceleration, the resonant frequency of the second resonant element will be shifted down. However any shifts in resonant frequency dues to thermal or mechanical stresses on the accelerometer will result in a shift in resonant frequency in the same direction for both the first resonant element and the second resonant element.

An advantage of the arrangement of the second embodiment is that the mass of the proof mass can be maximised for a given total size of the accelerometer. There is no need for a space separating first and second proof masses. The greater the total mass of the proof mass or proof masses, the greater the scale factor of the accelerometer.

Figure 3 illustrates an arrangement for drive and sense electrodes that can be used with both the first and second embodiments described. Figure 3 illustrates the drive and sense electrodes with the first embodiment as shown in Figure 1.

The first resonant element 16 is driven into a first mode of vibration by the application of an oscillating drive voltage to first drive electrode 50, positioned adjacent the first resonant element 16. The vibratory response of the first resonant element 16 is detected by monitoring the voltage on first sense electrode 52, positioned on an opposite side of the first resonant element to the first drive electrode 50. A frequency tracking oscillator, including amplifier 54 is used to maximise the vibratory response, thereby maintaining the first resonant element at a first resonant frequency. The frequency of the drive signal applied to the drive electrode 50 is output to a differential processing circuit 70.

An identical arrangement is used to maintain the second resonant element 26 in resonance. The second resonant element 26 is driven into a second mode of vibration by the application of an oscillating drive voltage to second drive electrode 60, positioned adjacent the second resonant element 26. The vibratory response of the second resonant element 26 is detected by monitoring the voltage on second sense electrode 62, positioned on an opposite side of the second resonant element to the second drive electrode 60. A frequency tracking oscillator, including amplifier 64 is used to maximise the vibratory response, thereby maintaining the second resonant element at a second resonant frequency. The frequency of the drive signal applied to the drive electrode 60 is output to the differential processing circuit 70.

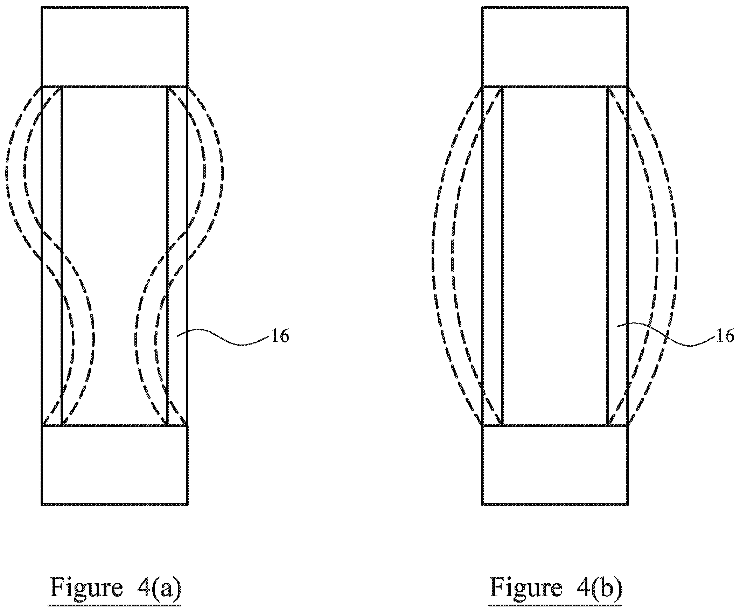

The first and second resonant elements can be driven into the same or different modes of vibration. Using different modes of vibration has an advantage that coupling between the vibration of the first and second resonant elements is reduced compared to when the same mode of vibration is used. Figure 4 illustrates two different mode shapes that can be used with a DEFT resonant element. Figure 4b shows an out-of-phase fundamental mode of vibration and Figure 4a shows an out-of-phase first order mode of vibration. Using different modes of vibration for the first and second resonant element may give rise to a different magnitude of shift in resonant frequency for a given applied strain. When combining the outputs from the first and second resonant elements, any difference in scale factor resulting from the use of different vibratory modes must be compensated for in the differential processing circuit 70.

The differential processing circuit 70 essentially subtracts the output from one resonant element from the output from the other resonant element, adjusting for any scale factor differences, to provide an output that is a measure of acceleration. Frequency shifts due to temperature variations of mechanical stresses are cancelled out, providing an accurate measure of acceleration.

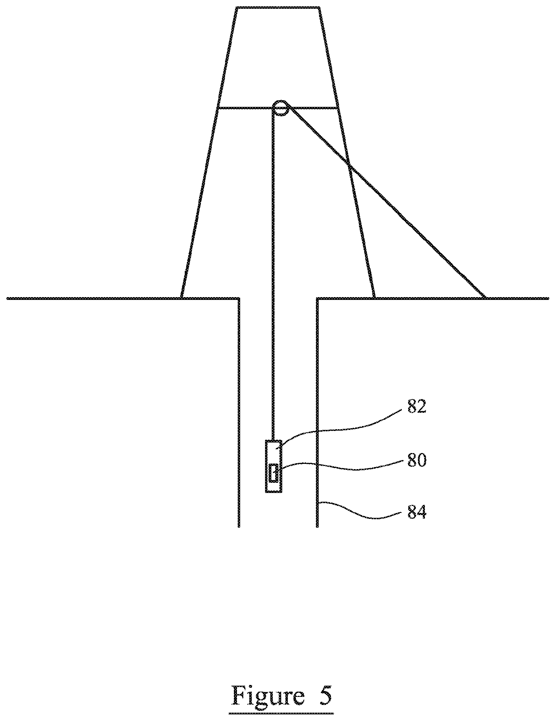

This accelerometer arrangement may be useful when a highly sensitive acceleration measurement is needed. One example is gravimetry, when small variations in gravity fields need to be measured. An accelerometer used in gravimetry is called a gravimeter. A gravimeter can be used for surveying in oil or gas extraction. Figure 5 illustrates a gravimeter down a bore hole. Measurements of the gravity field down a borehole can provide information about the density of the surrounding layers and so information about the presence of oil or gas reserves and their size and location. As shown in Figure 5, an accelerometer 80 in accordance with the invention is positioned within a borehole tool 82. The borehole tool is placed in the bore 84, suspended from a suitable structure on the surface. Gravimeters of this sort can be used in other applications, such as carbon storage monitoring, monitoring groundwater depletion, discovery of underwater aquifers, monitoring other processes underpinning the hydrological cycle, early-warning systems for earthquake-prone zones or for areas impacted by volcanic activity.

## Claims

1. An accelerometer comprising:
a frame (12, 32);
one or more proof masses (10, 20, 30) suspended from the frame by one or more flexures (14, 34) and movable relative to the frame along a sensing axis;
a first resonant element (16, 36) fixed between an anchor (8, 40) on the frame and the one or more proof masses, and extending from the anchor to the one or more proof masses along the sensing axis;
a second resonant element (26, 38) fixed between the anchor and the one or more proof masses and extending from the anchor to the one or more proof masses along the sensing axis in an opposite direction to the first resonant element, and
drive circuity (50, 60) configured to drive the first (16, 36) and second (26, 38) resonant elements into resonance and sense circuitry (52, 62) configured to detect changes in the resonant behaviour of the first and second resonant elements,
wherein the first (16, 36) and second (26, 38) resonant elements are double ended tuning fork resonant elements,
**characterised in that** the drive circuitry (50, 60) is configured to drive the first double ended tuning fork resonant element (16, 36) in an out-of-phase mode, and the drive circuitry (50, 60) is configured to drive the second double ended tuning fork resonant element (26, 38) in an out-of-phase mode.

2. An accelerometer according to claim 1, wherein the sense circuitry (52, 62) provides an output based on a difference between a resonant frequency of the first resonant element (16, 36) and a resonant frequency of the second resonant element (26, 38).

3. An accelerometer according to claim 1 or 2, wherein the drive circuitry (50, 60) is configured to drive the first (16, 36) and second (26, 38) resonant elements into different resonant modes to one another.

4. An accelerometer according to any one of the preceding claims, wherein the first (16, 36) and second (26, 38) resonant elements are substantially identical to one another.

5. An accelerometer according to any one of the preceding claims, wherein the one or more proof masses (30) consists of a single proof mass surrounding the anchor (40).

6. An accelerometer according to any one of claims 1 to 4, wherein the one or more proof masses (10, 20) consists of two substantially identical proof masses positioned on opposite sides of the anchor (8).

7. An accelerometer according to any one of the preceding claims, comprising a force amplifying lever (18, 28, 37, 39) between the first (16, 36) or second (26, 38) resonant element and the one or more proof masses (10, 20, 30).

8. An accelerometer according to any one of the preceding claims, wherein the frame (12, 32), one or more proof masses (10, 20, 30) and flexures (14, 34) are formed from a single piece of semiconductor material.

9. An accelerometer according to any one of the preceding claims, wherein the accelerometer is a micro electrical mechanical systems (MEMS) device.

10. A gravimeter comprising an accelerometer in accordance with any one of the preceding claims.

11. A borehole tool (82) comprising a gravimeter according to claim 10.

## Patentansprüche

1. Beschleunigungsmesser, umfassend:
einen Rahmen (12, 32);
eine oder mehrere Prüfmassen (10, 20, 30), die durch ein oder mehrere Biegeelemente (14, 34) am Rahmen aufgehängt und relativ zum Rahmen entlang einer Messachse bewegbar sind;
ein erstes Resonanzelement (16, 36), das zwischen einem Anker (8, 40) an dem Rahmen und der einen oder den mehreren Prüfmassen befestigt ist und sich in einer zu dem ersten Resonanzelement entgegengesetzten Richtung entlang der Messachse von dem Anker zu der einen oder den mehreren Prüfmassen erstreckt, und
eine Steuerkreisanordnung (50, 60), die zum Versetzen des ersten (16, 36) und des zweiten (26, 38) Resonanzelements in Resonanz konfiguriert ist, und eine Messschaltungsanordnung (52, 62), die zum Erkennen von Änderungen des Resonanzverhaltens des ersten und des zweiten Resonanzelements konfiguriert ist,
wobei das erste (16, 36) und das zweite (26, 38) Resonanzelement doppelendige Stimmgabel-Resonanzelemente sind,
**dadurch gekennzeichnet, dass** die Steuerkreisanordnung (50, 60) zum Antreiben des ersten doppelendigen Stimmgabel-Resonanzelements (16, 36) in einem phasenverschobenen Modus konfiguriert ist und die Steuerkreisanordnung (50, 60) zum Antreiben des zweiten doppelendigen Stimmgabel-Resonanzelements (26, 38) in einem phasenverschobenen Modus konfiguriert ist.

2. Beschleunigungsmesser nach Anspruch 1, wobei die Messschaltungsanordnung (52, 62) einen Ausgang auf Basis einer Differenz zwischen einer Resonanzfrequenz des ersten Resonanzelements (16, 36) und einer Resonanzfrequenz des zweiten Resonanzelements (26, 38) bereitstellt.

3. Beschleunigungsmesser nach Anspruch 1 oder 2, wobei die Steuerkreisanordnung (50, 60) zum Versetzen des ersten (16, 36) und des zweiten (26, 38) Resonanzelements in verschiedene Resonanzmodi zueinander konfiguriert ist.

4. Beschleunigungsmesser nach einem der vorhergehenden Ansprüche, wobei das erste (16, 36) und das zweite (26, 38) Resonanzelement miteinander im Wesentlichen identisch sind.

5. Beschleunigungsmesser nach einem der vorhergehenden Ansprüche, wobei die eine oder mehreren Prüfmassen (30) aus einer einzelnen, den Anker (40) umgebenden Prüfmasse bestehen.

6. Beschleunigungsmesser nach einem der Ansprüche 1 bis 4, wobei die eine oder mehreren Prüfmassen (10, 20) aus zwei im Wesentlichen identischen Prüfmassen bestehen, die auf entgegengesetzten Seiten des Ankers (8) positioniert sind.

7. Beschleunigungsmesser nach einem der vorhergehenden Ansprüche, umfassend einen Kraftverstärkungshebel (18, 28, 37, 39) zwischen dem ersten (16, 36) oder dem zweiten (26, 38) Resonanzelement und der einen oder den mehreren Prüfmassen (10, 20, 30).

8. Beschleunigungsmesser nach einem der vorhergehenden Ansprüche, wobei der Rahmen (12, 32), eine oder mehrere Prüfmassen (10, 20, 30) und Biegeelemente (14, 34) aus einem einzelnen Stück Halbleitermaterial hergestellt sind.

9. Beschleunigungsmesser nach einem der vorhergehenden Ansprüche, wobei der Beschleunigungsmesser eine Mikrosystem- (MEMS) -Vorrichtung ist.

10. Gravimeter, umfassend einen Beschleunigungsmesser nach einem der vorhergehenden Ansprüche.

11. Bohrlochwerkzeug (82), umfassend ein Gravimeter nach Anspruch 10.

## Revendications

1. Accéléromètre comprenant :
un cadre (12, 32) ;
une ou plusieurs masses étalon (10, 20, 30) suspendues au cadre par une ou plusieurs flexions (14, 34) et mobiles par rapport au cadre le long d'un axe de détection ;
un premier élément résonant (16, 36) fixé entre un ancrage (8, 40) sur le cadre et une ou plusieurs masses étalon, et s'étendant depuis l'ancrage jusqu'aux une ou plusieurs masses étalon le long de l'axe de détection ;
un second élément résonant (26, 38) fixé entre l'ancrage et les une ou plusieurs masses étalon et s'étendant depuis l'ancrage jusqu'aux une ou plusieurs masses étalon le long de l'axe de détection dans une direction opposée au premier élément résonant, et
une circuiterie de commande (50, 60) configurée pour commander les premier (16, 36) et second (26, 38) éléments résonants dans la circuiterie de résonance et de détection (52, 62) configurée pour détecter des changements du comportement de résonance des premier et second éléments résonants,
dans lequel les premiers (16, 36) et second (26, 38) éléments résonants sont des éléments résonants de diapason à double extrémité,
**caractérisé en ce que** la circuiterie de commande (50, 60) est configurée pour commander le premier élément résonant de diapason à double extrémité (16, 36) dans un mode déphasé, et la circuiterie d'entraînement (50, 60) est configurée pour commander le second élément résonant de diapason à double extrémité (26, 38) dans un mode déphasé.

2. Accéléromètre selon la revendication 1, dans lequel la circuiterie de détection (52, 62) fournit une sortie basée sur une différence entre une fréquence de résonance du premier élément résonant (16, 36) et une fréquence de résonance du second élément résonant (26, 38).

3. Accéléromètre selon la revendication 1 ou 2, dans lequel la circuiterie d'entraînement (50, 60) est configurée pour commander les premier (16, 36) et second (26, 38) éléments résonants dans des modes de résonance différents l'un de l'autre.

4. Accéléromètre selon l'une quelconque des revendications précédentes, dans lequel les premier (16, 36) et second (26, 38) éléments résonants sont essentiellement identiques entre eux.

5. Accéléromètre selon l'une quelconque des revendications précédentes, dans lequel les une ou plusieurs masses étalon (30) consistent en une seule masse étalon entourant l'ancrage (40).

6. Accéléromètre selon l'une quelconque des revendications 1 à 4, dans lequel les une ou plusieurs masses étalon (10, 20) consistent en deux masses étalon sensiblement identiques positionnées sur des côtés opposés de l'ancrage (8).

7. Accéléromètre selon l'une quelconque des revendications précédentes, comprenant un levier amplificateur de force (18, 28, 37, 39) entre le premier (16, 36) ou second (26, 38) élément résonant et les une ou plusieurs masses étalon (10, 20, 30).

8. Accéléromètre selon l'une quelconque des revendications précédentes, dans lequel le cadre (12, 32), les une ou plusieurs masses étalon (10, 20, 30) et les flexions (14, 34) sont formés à partir d'une seule pièce de matériau semi-conducteur.

9. Accéléromètre selon l'une quelconque des revendications précédentes, dans lequel l'accéléromètre est un dispositif de microsystèmes électromécaniques (MEMS).

10. Gravimètre composé d'un accéléromètre selon l'une quelconque des revendications précédentes.

11. Outil de forage (82) comprenant un gravimètre selon la revendication 10.
